# EUROPEAN PATENT APPLICATION

(11) **EP 4 502 054 A1**
(43) Date of publication of application: **05.02.2025**
(21) Application number: 23780611.2
(22) Date of filing: 28.03.2023
(51) Int. Cl.: C08L 57/00, B32B 15/08, B32B 27/20, C08F 2/44

(54) **COMPOSITION**

(30) Priority: 28.03.2022 JP 2022052522
(71) Applicant: Denka Company Limited, Tokyo 103-8338 (JP)
(72) Inventor: ONUKI,Suguru, Tokyo 103-8338 (JP); KANTO,Ryosuke, Tokyo 103-8338 (JP); ISHIGAKI,Yuhei, Tokyo 103-8338 (JP); YOSHIDA,Jun, Tokyo 103-8338 (JP)
(74) Representative: Müller-Boré & Partner Patentanwälte PartG mbB
(86) International application number: PCT/JP2023/012676
(87) International publication number: WO 2023/190602

(57) **Abstract**

A composition, comprising (A) a curable hydrocarbon-based resin; (C) a co-catalyst which is a metal compound or a semimetal compound; and (D) a chelating agent having one or two oxygen atoms in one molecule, wherein an amount of the component (D) per 1 mol of the component (C) contained in the composition is 2 mol or more.

## Description

### FIELD OF THE INVENTION

The present invention relates to a composition and a method for producing the same.

### BACKGROUND ART

Due to the shift of communication frequency to gigahertz bands and frequency bands higher than those, needs for insulating materials having low dielectric properties have increased. This is because a transmission loss is known to be approximately equal to the sum of a dielectric loss which is proportional to a dielectric tangent and a conductor loss. However, it is difficult for existing materials such as epoxy resins to achieve sufficiently low dielectric constant and dielectric loss. For this reason, a new monomer, also called an LDM (Low Dielectric Macromonomer), has been explored as a raw material.

For example, Patent Literature 1 discloses a curable composition containing a predetermined olefin-aromatic vinyl compound-aromatic polyene copolymer and a predetermined additive resin, which can reduce the dielectric constant and dielectric loss, as one type of LDM.

As described in Patent Literature 1, upon synthesis of LDM products, the compound containing a metal or semimetal such as zirconium, hafnium, aluminum, or boron is used as a catalyst or co-catalyst. Such a catalyst and a co-catalyst are usually used in such a manner that they are not removed but remain in the final product.

On the other hand, it is known that fisheyes in the obtained film result from aluminum residues present in an olefin polymerization solution. For this reason, an aluminum trapping agent contained attempts to inhibit fisheyes from occurring (Patent Literature 2).

### PRIOR ART

### Patent Literature

[Patent Literature 1] International Publication No. WO 2021/112088
[Patent Literature 2] Japanese Patent Laid-Open No. 2000-001577

### SUMMARY OF THE INVENTION

### TECHNICAL PROBLEM

In manufacture of LDM products, a problem has been that use of conventional metal compound as a catalyst or co-catalyst, causes gelling when the resulting composition obtained with the catalyst residue being contained is exposed to the atmosphere. Even though an attempt is made to use a conventional metal trapping agent in order to address this problem, there has been a problem that the dielectric constant and dielectric loss are adversely affected.

Moreover, another problem is that the process of removing the catalyst or co-catalyst residues is complicated, making it difficult to remove them completely and reliably.

As a result, with the conventional technology, a new problem has arisen in that gelling is less likely to be inhibited in manufacture of LDM products that require dielectric properties.

### SOLUTION TO PROBLEM

In order to solve the above-described problems, the following aspects may be provided in the present invention.

### Aspect 1.

A composition, comprising:
(A) a curable hydrocarbon-based resin;
(C) a co-catalyst which is a metal compound or a semimetal compound; and
(D) a chelating agent having one or two oxygen atom(s) in one molecule,
wherein an amount of the component (D) per 1 mol of the component (C) contained in the composition is 2 mol or more.

### Aspect 2.

The composition according to aspect 1, wherein the component (A) comprises an olefin-aromatic vinyl compound-aromatic polyene copolymer.

### Aspect s.

The composition according to aspect 2, wherein the component (A) satisfies the following conditions (1) to (4):
(1) a number average molecular weight of the copolymer is 500 or more and 100,000 or less;
(2) an aromatic vinyl compound monomer unit is an aromatic vinyl compound having 8 or more and 20 or less carbon atoms, and a content of the aromatic vinyl compound monomer unit is 0 mass% or more and 70 mass% or less;
(3) an aromatic polyene monomer unit is one or more selected from polyenes having 5 or more and 20 or less carbon atoms and having a plurality of vinyl groups and/or vinylene groups in the molecule, and a content of the vinyl group and/or vinylene group derived from the aromatic polyene monomer unit is 1.5 pieces or more and less than 20 pieces per number average molecular weight; and
(4) an olefin monomer unit is one or more selected from olefins having 2 or more and 20 or less carbon atoms, and a total of units of the olefin monomer, the aromatic vinyl compound monomer, and the aromatic polyene monomer is 100 mass%.

### Aspect 4.

The composition according to any one of aspects 1 to 3, further comprising
(B) a resin component comprising one or more selected from the group consisting of a thermoplastic hydrocarbon-based elastomer and a thermoplastic conjugated diene-based polymer.

### Aspect s.

The composition according to any one of aspects 1 to 4, wherein an amount of the component (D) is 0.5 parts by mass or more and 10 parts by mass or less per 100 parts by mass of the component (A).

### Aspect s.

The composition according to any one of aspects 1 to 5, further comprising
(E) a catalyst which is a metal compound or a semimetal compound.

### Aspect 7.

The composition according to claim 6, wherein an amount of the component (D) per 1 mol of the component (E) contained in the composition is 100 mol or more.

### Aspect s.

The composition according to any one of aspects 1 to 7, wherein the component (D) is free of a nitrogen atom in its molecule.

### Aspect 9.

The composition according to any one of aspects 1 to 8, wherein the component (D) comprises one or more selected from the group consisting of 4-tert-butylcatechol and acetylacetone.

### Aspect 10.

A cured product of the composition according to any one of aspects 1 to 9.

### Aspect 11.

A laminate, comprising:
a layer comprising the composition according to any one of aspects 1 to 9; and
a metal foil.

### Aspect 12.

A single-layer CCL, multilayer CCL, single-layer FCCL, or multilayer FCCL substrate comprising the cured product according to claim 10.

### Aspect 13.

A solution, comprising:
the composition according to any one of aspects 1 to 9; and
a solvent for dissolving the composition.

### ADVANTAGEOUS EFFECT OF INVENTION

The composition according to the present invention has an effect whereby gelling can be inhibited in a production step of LDM products that require dielectric properties.

### DETAILED DESCRIPTION OF THE INVENTION

In the specification, the term "sheet" also includes a concept of a film. Further, the term "film" described in the specification also includes the concept of a sheet. The term "composition" described in the present specification refers to a concept including a varnish. In other words, a composition particularly in liquid form is described as a varnish. The order of each step included in the method disclosed in the present specification may be freely changed chronologically as long as the effect can be exhibited. The numerical ranges in the present specification include the lower limits and the upper limits unless otherwise specified.

First, the composition according to the present invention is characterized in that it contains a metal compound or semimetal compound as a co-catalyst, which is a component (C), and a chelating agent having one or two oxygen atoms in one molecule, which is a component (D), in a predetermined ratio. The amount of the component (D) per 1 mol of the component (C) contained in the composition is 2 mol or more, and it may be preferably 2 mol or more and 10 mol or less and more preferably 2 mol or more and 7 mol or less. The amount of the component (D) per 1 mol of the component (C) contained in the composition being less than 2 mol arises problems such as gelling when the composition is exposed to the air or an increase in viscosity when water is added.

The component (C) is a co-catalyst that may be used in a catalytic amount in polymerization of a curable hydrocarbon-based resin (hereinafter may be simply referred to as "resin"), which is the component (A). The component (C) may, for example, contain one or more of any aluminum compounds or boron compounds.

An example of the aluminum compound may include an organoaluminum compound. Examples of the organoaluminum compounds include methylaluminoxane (also called methylalumoxane or MAO), modified methylaluminoxane (also called modified MAO or MMAO), solid polymethylaluminoxane (also called SMAO), and the like. These are commercially available from Tosoh Corporation under the trade names of TMAO-312, TMAO-211, TMAO-212, MMAO-3A, TMAO-341, and solid MAO. Furthermore, alkylaluminum compounds such as triisobutylaluminum and triethylaluminum may also be included.

An example of the boron compound may include an organoboron compound. Examples of the organic boron compounds include boronic acid, a boronic acid ester, a boron trifluoride alkyl ether, boron trifluoride phenol, and the like.

As examples of the component (C) (and a component (E) described later), those described in EP 08 72492 A2, Japanese Patent Laid-Open No. 11-130808, Japanese Patent Laid-Open No. 9-309925, International Publication No. WO 00/20426, EP 09 85689 A2, and Japanese Patent Laid-Open No. 6-184179, may also be further included.

The amount of component (C) may preferably be in a range of 0.01 to 10 parts by mass and more preferably in the range of 0.1 to 1 part by mass, relative to 100 parts by mass of the component (A). It is to be noted that, in the present specification, the component (A), and the component (B), when contained, may be collectively referred to as a "polymerization system".

The component (D) is a chelating agent having one or two oxygen atoms in one molecule, and is preferably free of a nitrogen atom in the molecule. Three or more oxygen atoms per molecule results in a problem that the dielectric property of a cured product of the composition will be worsened. The component (D) coordinates with the component (C) that has remained as a catalyst residue after having functioned as a catalyst or co-catalyst, and plays a role in rendering it innoxious. Also, the component (D) may also similarly coordinate with the component (E) which will be described later, to be able to exhibit a detoxification effect.

Although not wishing to be bound by any particular theory, it is conjectured that the chelating agent, having a plurality of groups having an oxygen atom (preferably a hydroxyl group or carbonyl group, not having a nitrogen atom, etc.) can efficiently coordinate with the component (C) dissolved in the polymerization system, and can sufficiently detoxify it. Also the component (D) preferably has no ester structure in the molecule.

The amount of the component (D) may preferably be 0.5 parts by mass or more, more preferably 0.6 parts by mass or more, more preferably 0.5 parts by mass or more or 0.6 parts by mass or more and 10 parts by mass or less, and still more preferably 0.6 parts by mass or more and 7 parts by mass or less, relative to 100 parts by mass of the component (A). Within the preferred range of the amount of the component (D), the catalyst residue may be sufficiently rendered innoxious, and an effect whereby adverse effects of the composition on the dielectric property is less likely to occur, is demonstrated. Within the preferred range of the amount of the component (D), the chelating agent that diffuses sufficiently throughout the resin components, facilitates inhibition of gelling upon exposure to the atmosphere and further provides an effect of facilitating inhibition of thickening when moisture is added.

The component (A) may be any curable hydrocarbon-based resin, which has a functional group that can be cured (thermally) in the presence of heat or a radical polymerization initiator. The presence of the component (A) allows a cured product of the present composition to satisfy heat resistance required for an electrical insulating material. The functional group is not limited as long as it may be cured by heat or radicals, but is preferably one or more of the group consisting of a vinyl group, a vinylene group, and an allyl group. For example, such a component (A) may be a polyfunctional vinyl aromatic copolymer obtained by the cationic polymerization reaction described in International Publication No. WO2018/181842 and International Publication No. 2017/115813, or it may be a polyphenylene-based ether resin having a functional group, such as SA-9000 manufactured by SABIC or OPE-2St manufactured by MITSUBISHI GAS CHEMICAL COMPANY, INC., or a polyether (ketone) having a functional group, or a polymer or copolymer having a 1,2-polybutadiene structure, such as the product name "Ricon" manufactured by Cray Valley S. A. Further, an example of the component (A) includes an olefin-aromatic vinyl compound-aromatic polyene copolymer obtained by a single-site coordination polymerization reaction. These may be used singly or may be a composition composed of a plurality thereof. Most preferably, the component (A) may contain a polyfunctional vinyl aromatic copolymer or an olefin-aromatic vinyl compound-aromatic polyene copolymer, the constituents of which are substantially carbon atoms and hydrogen atoms.

The composition according to a preferred embodiment of the present invention contains, as the component (A), an olefin-aromatic vinyl compound-aromatic polyene copolymer (hereinafter may be simply referred to as a "copolymer"). The copolymer is characterized in that it is obtained by copolymerizing each of monomers of an olefin, an aromatic vinyl compound, and an aromatic polyene by a single-site coordination polymerization reaction contributed by the component (C).

The olefin monomer is one or more selected from α-olefins having 2 or more and 20 or less carbon atoms and cyclic olefins having 5 or more and 20 or less carbon atoms, which is a compound composed of carbon and hydrogen, substantially containing no oxygen, nitrogen, or halogen. Examples of the α-olefin having 2 or more and 20 or less carbon atoms include ethylene, propylene, 1-butene, 1-hexene, 1-octene, 1-decene, 1-dodecene, 4-methyl-1-pentene, 3,5,5-trimethyl-1-hexene, and the like. Examples of the cyclic olefin having 5 or more and 20 or less include carbon atoms, norbornene and cyclopentene. The olefin that may be preferably used is a combination of ethylene with an α-olefin other than ethylene or a cyclic olefin, or ethylene alone. A mass ratio of ethylene alone or an α-olefin component other than ethylene contained/an ethylene component, which is preferably 1/7 or less and more preferably 1/10 or less, enables increasing the peel strength of the resulting cured product from copper foil or copper wiring, which is preferable. The content of an α-olefin monomer component other than ethylene contained in the copolymer is more preferably 6 mass% or less and further most preferably 4 mass% or less, or most preferably the olefin is ethylene alone. The glass transition temperature of a cured product of a copolymer described later may be adjusted by the type and content of the olefin.

When the total of the olefin monomer unit, aromatic vinyl compound monomer unit, and aromatic polyene monomer unit is taken as 100 mass%, the content of the olefin monomer unit in the present copolymer may be preferably 20 mass% or more, more preferably 25 mass% or more, and most preferably 30 mass% or more. The content of the olefin monomer unit being 20 mass% or more allows the toughness (elongation) and impact resistance of the cured product finally obtained to be improved, making it difficult to crack in the course of curing or crack during a heat cycle test of the cured product. In the present copolymer, the content of the olefin monomer unit is preferably 90 mass% or less.

The aromatic vinyl compound monomer is an aromatic vinyl compound having 8 or more and 20 or less carbon atoms, and examples thereof include styrene, paramethylstyrene, paraisobutylstyrene, various vinylnaphthalenes, and various vinylanthracenes.

The content of the aromatic vinyl compound monomer unit contained in the present copolymer may be 0 mass% or more and 70 mass% or less, and it may be preferably 10 mass% or more and 60 mass% or less. With the content of the aromatic vinyl compound monomer unit of 70 mass% or less, the glass transition temperature of the finally obtained cured product of the resin composition becomes lower than a temperature in the vicinity of room temperature, making it possible to improve toughness and elongation at low temperatures, which is preferred. With the content of aromatic vinyl compound monomer unit of 10 mass% or more, effects whereby the aromatic property of the present copolymer is improved, the compatibility with a flame retardant and filler is improved, bleeding out of the flame retardant can be avoided, and the filling property of the filler can be improved, are demonstrated. The content of aromatic vinyl compound monomer unit being 10 mass% or more also enables obtaining a cured product with high peel strength from copper foil and copper wiring.

The aromatic polyene monomer may be a polyene having 5 or more and 20 or less carbon atoms and having a plurality of vinyl groups and/or vinylene groups in the molecule, being preferably various (ortho, meta, and para) divinylbenzenes or a mixture thereof, and a compound composed of carbon and hydrogen, substantially containing no oxygen, nitrogen, or halogen, having an aromatic vinyl structure such as divinylnaphthalene, divinylanthracene, p-2-propenylstyrene, and p-3-butenylstyrene. Alternatively, a bifunctional aromatic vinyl compound described in Japanese Patent Laid-Open No. 2004-087639, for example, 1,2-bis(vinylphenyl)ethane (abbreviation: BVPE) may be used. Among these, various (i.e., ortho-, meta- and para-) divinylbenzenes, or mixtures thereof are preferably used, and a mixture of meta and paradivinylbenzene is most preferably used. In the present specification, these divinylbenzenes may be collectively referred to as divinylbenzenes. Use of divinylbenzenes as the aromatic polyene is preferred, because the curing efficiency is high in a curing process to achieve easy curing.

Each of the monomers of the olefin, aromatic vinyl compound, and aromatic polyene may further include an olefin containing a polar group such as an oxygen atom, a nitrogen atom, etc., an aromatic vinyl compound containing an oxygen atom, a nitrogen atom, etc., or an aromatic polyene containing an oxygen atom, a nitrogen atom, etc. The total mass of the monomers containing these polar groups is preferably 10 mass% or less, more preferably 3 mass% or less, relative to the total mass of the composition, and it is most preferable that no monomers containing a polar group be contained. A proportion of the total mass of the monomer containing the polar group of 10 mass% or less enables improving dielectric properties (low dielectric constant, low dielectric loss) of a cured product made by curing the present composition.

Of the present copolymers, as an aspect of not containing the aromatic vinyl compound monomer unit (olefin-aromatic polyene copolymer), an ethylene-divinylbenzene copolymer, an ethylene-propylene-divinylbenzene copolymer, an ethylene-1-butene-divinylbenzene copolymer, an ethylene-1-hexene-divinylbenzene copolymer, an ethylene-1-octene-divinylbenzene copolymer, and the like, may be exemplified.

Of the present copolymers, as an aspect of containing the aromatic vinyl compound monomer unit (olefin-aromatic vinyl compound-aromatic polyene copolymer), an ethylene-styrene-divinylbenzene copolymer, an ethylene-propylene-styrene-divinylbenzene copolymer, an ethylene-1-hexene-styrene-divinylbenzene copolymer, an ethylene-1-octene-styrene-divinylbenzene copolymer, and the like, may be exemplified.

The number average molecular weight (Mn) of the copolymer may be 500 or more and 100,000 or less, preferably 500 or more and 50,000 or less, more preferably 500 or more and 20,000 or less, and still more preferably 500 or more and 10,000 or less. Mn being 100,000 or less makes it possible to obtain an appropriate viscosity for a varnish, and an effect of improving handleability upon use of the composition, is obtained.

The weight-average molecular weight (Mw) of the present copolymer may be preferably 10,000 or more and 200,000 or less, more preferably 20,000 or more and 200,000 or less, and still more preferably 20,000 or more and 150,000 or less. The value Mw/Mn obtained by dividing a weight-average molecular weight by a number average molecular weight may preferably be in a range of 2.0 ≤ Mw/Mn ≤ 13.0, more preferably 2.0 ≤ Mw/Mn ≤ 12.0, and still more preferably 2.0 ≤ Mw/Mn ≤ 10.0.

The number average molecular weight and weight-average molecular weight described in the present specification refer to the values measured as molecular weights in terms of standard polystyrene, determined by high temperature gel permeation chromatography (HT-GPC). The measurement conditions for the HT-GPC method described in the present specification are as follows:
Measurement apparatus: HLC-8321GPC/HT manufactured by Tosoh Corporation
Column: TSKgeIGMHHR-H (20) HT, φ7.8 × 300mm (3 columns)
Column temperature: 140°C
Detector: RI
Solvent: Orthodichlorobenzene
Liquid flow rate: 1.0 ml/min
Sample concentration: 0.2 wt/vol%
Sample injection volume: 100 µL

In the present copolymer, the content of a vinyl group and/or a vinylene group (preferably the vinyl group) derived from the aromatic polyene unit is 1.5 pieces or more and less than 20 pieces per number average molecular weight and is preferably 2 pieces or more and less than 7 pieces. The content of the vinyl group and/or vinylene group being 1.5 pieces or more enables providing a cured product with high cross-linking efficiency and a sufficient cross-linking density. The content of the vinyl groups derived from the aromatic polyene units (divinylbenzene units) per number average molecular weight in the copolymer may be obtained by comparing the number average molecular weight (Mn) in terms of standard polystyrene determined by a GPC (gel permeation chromatography) method known to the skilled person with the vinyl group content derived from the aromatic polyene units, determined by ¹H-NMR measurement. As an example, in the case where the content of the vinyl group derived from the aromatic polyene unit (divinylbenzene units) in the copolymer is 3.2 mass% resulting from comparison of the intensity of each peak area obtained by ¹H-NMR measurement, and the number average molecular weight in terms of standard polystyrene by GPC measurement is 2100, the molecular weight of the vinyl group derived from the aromatic polyene unit in the number average molecular weight is 67.5, which is the product of these. The product is divided by 27, which is the formula weight of the vinyl group, to obtain 2.5. That is, the content of the vinyl group derived from the aromatic polyene unit per number average molecular weight in the present copolymer is determined to be 2.5 pieces. The attribution of peaks obtained by ¹H-NMR measurement of the copolymer is known in literature. Further, a method for obtaining the composition of the copolymer from the comparison of the peak areas obtained by ¹H-NMR measurement is also known. Further, in the specification, the content of the divinylbenzene unit in the copolymer is determined from the peak intensity of the vinyl group derived from the divinylbenzene unit (according to ¹H-NMR measurement). That is, from the content of the vinyl group derived from the divinylbenzene unit, the content of the divinylbenzene unit is determined by assuming that one piece of vinyl group is derived from one piece of divinylbenzene unit in the copolymer.

### <Curable polyether-based resin>

The component (A) may contain a curable polyether-based resin such as a curable polyphenylene ether or a polyether. As such a polyphenylene ether, commercially available known polyphenylene ethers may be used. The number average molecular weight of the polyphenylene ether is optional, preferably 10000 or less, and most preferably 5000 or less, in consideration of the moldability of the composition. The number average molecular weight is preferably 500 or more, most preferably 1000 or more. Also, in the case of addition for the purpose of curing the present composition, molecular end is preferably modified and/or a plurality of functional groups are preferably contained in one molecule. Examples of the functional groups include functional groups such as an allyl group, a vinyl group, and an epoxy group, and the functional group is most preferably a radically polymerizable functional group, particularly preferably a vinyl group, and further preferably one or more of the group consisting of a (meth)acrylic group and an aromatic vinyl group. That is, in the present composition, a bifunctional polyphenylene ether in which both ends of the molecular chain are modified with radically polymerizable functional groups, is particularly preferable. Examples of such polyphenylene ethers include Noryl (trademark) SA9000 manufactured by SABle, and particularly preferably a bifunctional polyphenylene ether oligomer (OPE-2 St) manufactured by Mitsubishi Gas Chemical Company, Inc., may be used. The amount of polyphenylene ether used in the present composition is preferably 1 to 200 parts by mass and more preferably 10 to 100 parts by mass relative to 100 parts by mass of the copolymer. As the polyether-based resin, aromatic polyethers (ELPAC HC-F series) manufactured by JSR Corporation may also be used. The amount of the polyether-based resin such as the polyphenylene ether used in the present composition is preferably 1 to 200 parts by mass and more preferably 1 to 100 parts by mass relative to 100 parts by mass of the component (A).

### <Curable aromatic polyene-based resin>

The curable aromatic polyene-based resin that may be contained in the component (A) includes a divinylbenzene-based reactive hyperbranched copolymer (PDV) manufactured by NIPPON STEEL Chemical & Material Co., Ltd. Such PDV is described, for example, in literature "Synthesis of polyfunctional aromatic vinyl copolymers and development of novel lPN-type low dielectric loss material using the same" (M. Kawabe et al., Journal of The Japan Institute of Electronics Packaging, p. 125, Vol. 12, No. 2 (2009)). Further, examples of the aromatic polyene-based resin also include an aromatic polyene polymer resin containing the above-mentioned aromatic polyene monomer as a main constituent unit.

The present composition may further contain, as the component (B), a resin component containing one or more selected from the group consisting of a thermoplastic hydrocarbon-based elastomer and a thermoplastic conjugated diene-based polymer. The component (B) is by definition distinct from the component (A), and does not include the component (A) within its definition.

### <Thermoplastic hydrocarbon-based elastomer>

The amount of thermoplastic hydrocarbon-based elastomer that may be contained in the component (B) is preferably 1 to 500 parts by mass and more preferably 1 to 200 parts by mass relative to 100 parts by mass of the copolymer. Examples of suitable hydrocarbon-based elastomers include one or more elastomers selected from an ethylene-based or a propylene-based elastomer, a conjugated diene-based polymer, a block copolymer or random copolymer of an aromatic vinyl compound - a conjugated diene-based compound, and a hydrogenated product thereof. The number average molecular weight of the hydrocarbon-based elastomer is 1000 or more, more preferably 2000 or more, still more preferably 20000 or more, and most preferably 30000 or more. The number average molecular weight of the hydrocarbon-based elastomer is preferably 80000 or less, more preferably 60000 or less.

Examples of the ethylene-based elastomer that may be contained in the component (B) include an ethylene-octene copolymer, an ethylene-α-olefin copolymer such as ethylene-1-hexene copolymer, EPR and EPDM, and examples of the propylene-based elastomer include an atactic polypropylene, a polypropylene having low stereoregularity, and a propylene-α-olefin copolymer such as propylene-1-butene copolymer.

Examples of the thermoplastic conjugated diene-based polymer that may be contained in the component (B) include polybutadiene and 1,2-polybutadiene. Examples of the aromatic vinyl compound-conjugated diene-based block copolymer or random copolymer, and a hydride (hydrogenated product) thereof include SBS, SIS, SEBS, SEPS, SEEPS, and SEEBS. 1,2-Polybutadiene that is suitably used is available, for example, as a product manufactured by JSR Corporation, and liquid polybutadienes: product names of B-1000, 2000, and 3000 are available from Nippon Soda Co., Ltd. Further, examples of the copolymer containing a 1,2-polybutadiene structure that may be preferably used include "Ricon 100" manufactured by TOTAL Cray Valley. When one or a plurality of resins selected from these hydrocarbon-based elastomers are liquid (viscosity of approximately 300,000 mPa·S or less) in particular at room temperature (25°C), from the viewpoint of handleability and moldability (handleability as a thermoplastic resin) of the present composition in uncured state, the amount used is preferably 1 to 30 parts by mass and particularly preferably 1 to 20 parts by mass, relative to 100 parts by mass of the present copolymer.

The present composition may further contain any of optional additional components exemplified below, with the proviso that the effect of the present composition is not impaired.

### <Curing agent>

The curing agent that may be used in the present composition may be any known curing agent that may be used for polymerization or curing of conventional aromatic polyenes or aromatic vinyl compounds. Examples of such a curing agent include a radical polymerization initiator, a cationic polymerization initiator, and an anionic polymerization initiator, and a radical polymerization initiator may be preferably used. Preferably, the curing agent is an organic peroxide-based (peroxide) or azo-based polymerization initiator, which may be freely selected depending on the application and conditions. Catalogs showing organic peroxides may be downloaded from the following NOF CORPORATION websites.
https://www.nof.co.jp/business/chemicalchemical/product01
The organic peroxide is also described in the catalog and the like of FUJIFILM Wako Pure Chemical Corporation and Tokyo Chemical Industry Co., Ltd. The curing agent may be available from these companies. Also, a known photopolymerization initiator using light, ultraviolet rays, or a radiation may be used as the curing agent. Examples of the curing agents using the photopolymerization initiator include a photo radical polymerization initiator, a photo cationic polymerization initiator, or a photo anionic polymerization initiator. Such photopolymerization initiators are available, for example, from Tokyo Chemical Industry Co., Ltd. Furthermore, curing may be performed by radiation or electron beam itself. Alternatively, cross-linking and curing may be performed by thermal polymerization of the raw materials contained without a curing agent.

The amount of the curing agent used is not particularly limited, and in general preferably 0.01 to 10 parts by mass relative to 100 parts by mass of the composition. The composition preferably excludes a curing agent or a solvent. In the case where a curing agent such as peroxide-based (peroxide) or azo-based polymerization initiator is used, the curing treatment is performed at an appropriate temperature and time in consideration of the half-life thereof. The conditions in this case are optional according to the curing agent, and in general, a temperature range of about 50°C to 200°C is suitable.

### <Monomer>

The amount of monomer that may be contained in the present composition is arbitrary, but is preferably 10 parts by mass or less relative to 100 parts by mass of the copolymer. Incidentally, the composition may contain substantially no monomers. With an amount of monomers of 10 parts by mass or less, the uncured composition has no viscous property, and easy moldability as a thermoplastic resin is achieved. Further, with a content of easily volatile monomers below a certain level, the odor at the uncured stage causes no problem. In the case where a solvent is added to a composition to take a product form in varnish form, there is a problem that monomers are lost as the solvent (medium) evaporates during use, so that substantial monomer content tends to decrease. Further, in the case where the product form is an uncured sheet, with a certain amount or less of monomers contained, change in the monomer content during storage hardly occurs. The monomer that may be suitably used in the present composition has a molecular weight of preferably less than 1000, more preferably less than 500. Monomers that may be suitably used in the composition of the present invention are aromatic vinyl compound monomers, aromatic polyene monomers, and/or polar monomers. The monomer is preferably a monomer capable of being polymerized by a radical polymerization initiator, and more preferably one or more of the group consisting of the aromatic vinyl compounds or aromatic polyenes. Further, BVPE (1,2-bis(vinylphenyl)ethane) described in Japanese Patent Laid-Open No. 2003-212941 may also be preferably used. From the viewpoint of enhancing the mechanical strength (elastic modulus) of a cured product at high temperature, the amount of aromatic polyene is preferably 1 part by mass or more and 30 parts by mass or less relative to 100 parts by mass of the copolymer. Further, a relatively small amount of polar monomer may be used for the purpose of imparting adhesiveness to other materials required as an insulating material or improving the cross-linking density. Examples of the above-mentioned polar monomer include various maleimides, bismaleimides, maleic anhydride, glycidyl (meth)acrylate, triallyl isocyanurate, tri(meth)acrylic isocyanurate, and trimethylolpropane tri(meth)acrylate. Usable maleimides and bismaleimides are described, for example, in International Publication No. WO 2016/114287 and Japanese Patent Laid-Open No. 2008-291227, and may be purchased, for example, from Daiwa Kasei Industry Co., Ltd. or Designer Molecules Inc. As these maleimide group-containing compounds, bismaleimides are preferred from the viewpoints of solubility in an organic solvent, high frequency properties, high adhesiveness to a conductor, moldability of a prepreg, etc.

As bismaleimides, the bismaleimides represented by the following formula (B-1) are preferred.

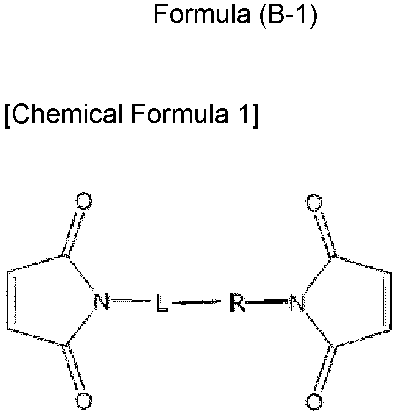

In Formula (B-1), R represents an alkylene group having 5 or more carbon atoms, and L represents a single bond or a divalent linking group. R and L each independently may have a substituent. The maleimides represented by Formula (B-1) are preferably represented by the following Formula (B-2).

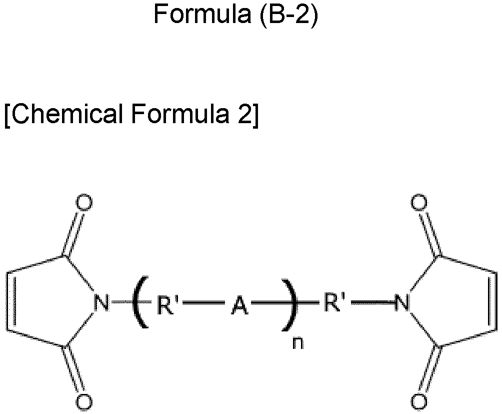

In Formula (B-2), R' each independently represent an alkylene group having 5 or more carbon atoms which may have a substituent, and A each independently represent an alkylene group having 5 or more carbon atoms which may have a substituent, or a divalent group having an aromatic ring which may have a substituent. Further, n represents an integer from 1 to 10.

Examples of maleimides represented by Formula (B-2) include compounds represented by the following Formula (B-3). In the formula, n represents an integer from 1 to 10. Examples of the compound represented by Formula (B-3) include BMI-1500 (n=1.3 on average) manufactured by Designer Molecules Inc.

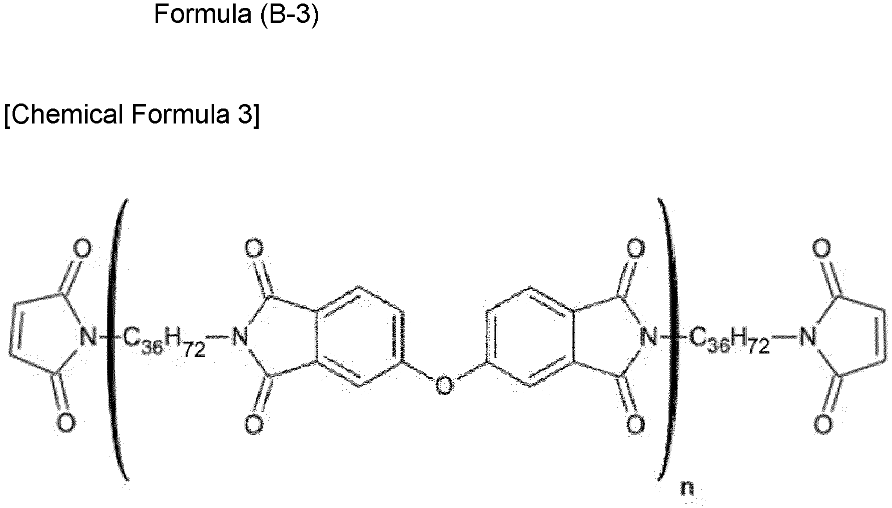

Bismaleimides may be used as a polyaminobismaleimide compound. The polyaminobismaleimide compound is obtained, for example, from a Michael addition reaction of a compound having two maleimide groups at a terminal and an aromatic diamine compound having two primary amino groups in a molecule. For obtaining high cross-linking efficiency with a small amount of addition, it is preferable to use a polar monomer having a polyfunctional group containing two or more functional groups, and examples thereof include bismaleimides, triallyl isocyanurate (TAIC), and trimethylolpropane tri(meth)acrylate. The amount of the polar monomer that may be contained in the composition is in the range of 0.1 to 10 parts by mass, preferably 0.1 to 5 parts by mass, relative to 100 parts by mass of the copolymer. By using 10 parts by mass or less, the dielectric constant and dielectric tangent of the resulting cured product may be reduced.

The present composition may further include, as the component (E), a catalyst of any metal or semimetal compound, which may be used in a catalytic amount in polymerization of the component (A). The component (E) is, by definition, distinct from the component (C), i.e., not including the component (C). The component (E) may preferably include one or more of a zirconium compound or a hafnium compound.

Examples of the zirconium compound or hafnium compound include a compound represented by the following general formula (I). 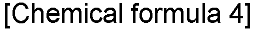 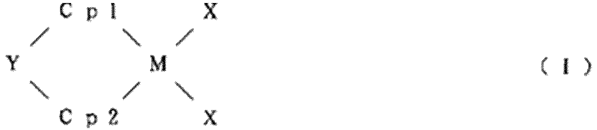 In the above formula, M is an element selected from zirconium or hafnium. Cp1 and Cp2 are each a cyclopentadienyl group having no substituent, or a cyclopentadienyl group having one or two alkyl substituents (preferably having 1 to 3 carbon atoms) and having no cyclic structure. Cp1 and Cp2 may be the same as or different from each other. One of the Cp1 and Cp2 groups may be an indenyl group having no substituent, or an indenyl group having one or two alkyl substituents (preferably having 1 to 3 carbon atoms) and having no cyclic structure.
Y is an element having bonds with Cp1 and Cp2 and is selected from carbon, silicon, germanium, or boron, having a hydrogen atom or a substituent, and the substituent (preferably an alkyl group, a phenyl group or the like) may be different from or the same as each other and may have a cyclic structure (cyclohexyl structure or the like).
Xs are each independently selected from the group consisting of hydrogen, halogen, an alkyl group, and an aryl group, or two Xs are bonded to form a diene group.

Examples of such zirconium compounds or hafnium compounds include those such as dimethylmethylenebiscyclopentadienylzirconium dichloride, diphenylmethylenebiscyclopentadienylzirconium dichloride, dimethylmethylene(cyclopentadienyl)(1-indenyl)zirconium dichloride, and diphenylmethylene(cyclopentadienyl)(1-indenyl)zirconium dichloride.

The amount of component (D) per 1 mol of the component (E), contained in the composition may be 100 mol or more and preferably 100 mol or more and 500 mol or less. The amount of component (E) relative to 100 parts by mass of the component (A) may be in a range of 0.001 to 10 parts by mass and more preferably 0.01 to 5 parts by mass.

### <Solvent (medium)>

An appropriate solvent may be added to the present composition on an as needed basis. The solvent is used to adjust the viscosity and fluidity of the composition. The solvent is preferably volatile, and, for example, cyclohexane, toluene, ethylbenzene, acetone or isopropanol is used. The amount used is preferably 10 parts by mass or less relative to 100 parts by mass of the copolymer from the viewpoint of moldability and handling of the composition before curing as a thermoplastic resin, and it is more preferable that substantially no solvent be used from the viewpoint of removal during curing and after curing. Substantially no solvent used means preferably 5 parts by mass or less, more preferably 1 part by mass or less, and most preferably 0 parts by mass. In the case of using as a varnish, it is preferable to add an appropriate solvent to the present composition. The solvent is used to adjust the viscosity and fluidity of the composition as a varnish. As the solvent, a solvent having a boiling point of a certain level or more is preferred, because an applied film having a uniform thickness is obtained with a solvent having a high boiling point under atmospheric pressure, that is, having a low volatility. The preferred boiling point is approximately 100°C or more, preferably 130°C or more and 300°C or less, under atmospheric pressure. Examples of the solvent suitably used for a varnish include toluene, xylene, mesitylene, ethylbenzene, limonene, ethylene glycol methyl ether acetate, ethylene glycol monoethyl ether acetate, and ethylene glycol monobutyl ether. The amount used is preferably in the range of 10 to 2000 parts by mass relative to 100 parts by mass of the present composition.

The present composition may further contain one or more selected from a filler, a flame retardant, and a surface modifier. The present composition may become a matrix of a cured product. When cured, the present composition may contain one or more selected from these fillers, flame retardants, and surface modifiers in order to improve the filling property of other materials, and containing these facilitates a cured product to exhibit impact resistance and toughness even after curing.

### <Filler>

Examples of the fillers that may be contained in the present composition include an inorganic and organic filler. These fillers are added for the purpose of controlling the coefficient of thermal expansion, controlling the thermal conductivity, and reducing the cost, and the amount used thereof is optional depending on the purpose. The present composition may contain a large amount of inorganic filler, in particular, and the amount used thereof may reach 2000 parts by mass relative to 100 parts by mass of the copolymer. In particular, in the case of adding an inorganic filler, it is preferable to use a known surface modifier, for example, a silane coupling agent. In particular, for the purpose of producing a composition excellent in low dielectric constant and low dielectric loss, which is one of the objects of the present invention, boron nitride (BN) and/or silica are preferred as the inorganic filler, and silica is more preferred. Among silicas, fused silica is preferred. From the viewpoint of low dielectric properties, since the dielectric constant may increase high with a large amount of addition or compounding, in particular, the filler in amount of preferably less than 500 parts by mass, more preferably less than 400 parts by mass, relative to 100 parts by mass of the copolymer is used. In order to improve the low dielectric properties (low dielectric constant and low dielectric loss tangent), a hollow filler or a filler having a shape with many voids may be added.

Alternatively, an organic filler such as high molecular weight or ultra-high molecular weight polyethylene may be used instead of inorganic fillers. It is preferable that the organic filler be crosslinked by itself from the viewpoint of heat resistance, and it is preferable that the organic filler be used in a form of fine particles or powder. These organic fillers may suppress the increase in dielectric constant and dielectric tangent. The amount of the filler used is most preferably 1 part by mass or more and less than 400 parts by mass relative to 100 parts by mass of the copolymer.

Meanwhile, in the present composition, a high dielectric constant insulating filler having a dielectric constant at 1 GHz of preferably 3 to 10000, more preferably 5 to 10000, may be mixed and dispersed to prepare an insulating cured product having a high dielectric constant insulating layer having a dielectric constant of preferably 3.1 to 20, with suppressed increase in dielectric tangent (dielectric loss). With increase in the dielectric constant of the film made of insulating cured product, downsizing of a circuit and increase in capacity of a capacitor may be achieved, which contribute to downsizing of electric components for high frequencies. The high dielectric constant and low dielectric tangent insulating layer is suitable for applications such as capacitors, inductors for resonant circuits, filters, and antennas. Examples of the high dielectric constant insulating filler used in the present invention include inorganic fillers and insulated metal particles. Specific examples include known high dielectric constant inorganic fillers such as barium titanate and strontium titanate, and other examples are specifically described in, for example, Japanese Patent Application Laid-Open No. 2004-087639.

### <Flame retardant>

The flame retardant that may be contained in the present composition may be, from the viewpoint of maintaining the low dielectric constant and the low dielectric tangent, a known organic phosphorus-based flame retardant such as a phosphoric ester or a condensate thereof, a known bromine-based flame retardant and red phosphorus. In particular, among phosphoric acid esters, a compound having a plurality of xylenyl groups in the molecule is preferred from the viewpoint of flame retardancy and low dielectric tangent property.

In addition to the flame retardants, flame retardant aids including antimony compounds such as antimony trioxide, antimony tetroxide, antimony pentoxide and sodium antimonate, or nitrogen-containing compounds such as melamine, triallyl-1,3,5-triazine-2,3,4-(1H, 3H, 5H)-trione, and 2,4,6-triallyloxy-1 ,3,5-triazine may be added. In general, the total amount of these flame retardants and flame retardant aids is preferably 1 to 100 parts by mass relative to 100 parts by mass of the composition. Alternatively, 30 to 200 parts by mass of the polyphenylene ether (PPE)-based resin having a low dielectric constant and excellent flame retardancy may be compounded relative to 100 parts by mass of the flame retardant.

### <Surface modifier>

The present composition may further contain various surface modifiers for the purpose of improving adhesiveness to a filler, a copper plate, and wiring. The amount of the surface modifier used is preferably 0.01 to 10 parts by mass, more preferably 0.1 to 5 parts by mass, relative to 100 parts by mass of the present composition other than the surface modifier. Examples of the surface modifier include various silane coupling agents and titanate-based coupling agents. One or a plurality of various silane coupling agents and titanate-based coupling agents may be used.

The present composition may be also in a varnish form in viscous liquid state depending on the composition and compounding ratio. For example, by using a sufficient amount of solvent and/or by using an appropriate amount of a liquid monomer, a varnish form may be obtained. For use as a varnish, it is preferable to add an appropriate solvent to the present composition. The solvent is used to adjust the viscosity and fluidity of the composition as a varnish. A solvent having a boiling point at a certain level or more is preferred, because the solvent having a high boiling point under atmospheric pressure, that is, low volatility, allows a uniform thickness of the applied film to be produced. The preferred boiling point is approximately 100°C or more, preferably 130°C or more and 300°C or less, under atmospheric pressure. Examples of the solvent suitably used for a varnish include xylene, mesitylene, ethylbenzene, limonene, ethylene glycol methyl ether acetate, ethylene glycol monoethyl ether acetate, and ethylene glycol monobutyl ether. The amount used is preferably in the range of 10 to 2000 parts by mass relative to 100 parts by mass of the present composition. A composition in varnish form may also be produced by utilizing polymerization liquid containing the present copolymer obtained by polymerization. For example, the polymerization liquid may undergo condensation treatment or treatment of removing residual monomers, and a solvent, other resin components, various additives, or the like may be added, if necessary, regulated for the component concentration or the solution viscosity, and the like, for production.

The varnish may be, for example, applied to a base material, or a base material may be impregnated with the varnish, and the solvent or the like may be removed by drying or the like, so that the varnish may be made into an uncured or semi-cured molded product. Generally, the molded product is in a form of a sheet, film, or tape.

### <Curing>

The present composition may be cured by a known method by reference to curing conditions (temperature, time and pressure) of the curing agent contained. In the case where the curing agent used is a peroxide, the curing conditions may be determined by reference to the half-life temperature and the like disclosed for each peroxide.

The present composition may be used as various insulating materials for wiring, preferably wiring of high frequency signals, such as coverlays, solder resists, build-up materials, interlayer insulators, bonding sheets, interlayer adhesives, and bumps for flip chip bonders. Further, the composition may be used as an electrically insulating layer or an adhesive layer of a base material/substrate such as a single-layer or multi-layer printed circuit board, a flexible printed circuit board, a CCL (copper clad laminate) or FCCL (flexible copper clad laminate) base material.

### <Viscosity>

The viscosity of the composition in the present specification shall be determined according to JIS Z 8803:2011 when the composition was prepared as a 50 mass% toluene solution. The viscosity of the present composition at 25°C may be 100,000 cP or less at a shear rate of 1 s⁻¹, preferably 10,000 cP or less or 9,000 cP or less, more preferably 8,000 cP or less, and more preferably 5,000 cP or less. The lower limit of the viscosity is not particularly limited, but may be, for example, 500 cP or more and preferably 1,000 cP or more. Within such ranges of the viscosity, an effect of improving handleability as a varnish is obtained.

### <Production Method>

The composition containing the above-described copolymer may be obtained by allowing a raw material solution prepared by mixing the above-described olefin monomer, aromatic vinyl compound monomer, and aromatic polyene monomer in an appropriate solvent to undergo a single-site coordination polymerization reaction. In another embodiment, a step of polymerization in liquid monomers without using a solvent may be employed instead.

Examples of the solvents that may be used include a single or mixed solvent of saturated aliphatic solvents, aromatic hydrocarbons or halogenated hydrocarbons, such as pentane, hexane, heptane, cyclohexane, methylcyclohexane, benzene, toluene, ethylbenzene, xylene, mesitylene, limonene, chloro-substituted benzene, chloro-substituted toluene, methylene chloride, and chloroform. Preferably, a mixed alkane-based solvent, cyclohexane, toluene, ethylbenzene, and the like, may be used as the solvents.

The present copolymer may be produced without using a chain transfer agent, but the chain transfer agent may be used to lower the molecular weight. As such a chain transfer agent, a known chain transfer agent used with a so-called single-site coordination polymerization catalyst may be used, and examples thereof include, for example, hydrogen, alkylaluminums such as triisobutylaluminum, and 9-BBN as described in Chung T. C.: Macromolecules, 26, 3467 (1993).

A facility capable of producing the present composition may be, for example, a single or a plurality of connected tank polymerization cans, or a single or a plurality of connected linear or loop type pipe polymerization facilities. The pipe polymerization vessel may have various known mixers such as a dynamic or static mixer and a static mixer also used for heat removal, and various known coolers such as a cooler equipped with a thin tube for heat removal. A batch type preliminary polymerization vessel may also be included. Furthermore, a gas phase polymerization step may be adopted.

The polymerization temperature is preferably 0 to 200°C. The temperature of 0°C or higher is industrially advantageous because of a high polymerization rate, while the temperature of 200°C or lower has an effect whereby a transition metal compound is less likely to be decomposed. Industrially, the temperature is more preferably 30 to 160°C and particularly preferably 50 to 160°C. Pressure upon polymerization is generally preferably 1 to 100 atm, more preferably 1 to 30 atm, and industrially most preferably 1 to 10 atm.

Following completion of polymerization, an arbitrary step may be employed in recovering the copolymer from the reaction system, and preferably a steam stripping method or crumb forming method, which are known as methods for recovering raw rubber, may be employed. In a laboratory, a method for allowing a copolymer to be precipitated in a large amount of methanol, which is known as a methanol precipitation method, is generally convenient. Alternatively, without recovering the copolymer, a solvent and residual monomers may be totally or partially removed from polymerization liquid by evaporation using a rotary evaporator, film evaporator, or the like, and the resulting polymerization solution may be diluted with a solvent and used as a varnish.

### EXAMPLES

**[Table 1]**

| | Ethylene content | 1-Hexene content | Styrene content | Vinyl group of divinylbenzene | Number average molecular weight | Weight average molecular weight | Molecular weight distribution |
|---|---|---|---|---|---|---|---|
| Copolymerized oligomer or polymer | mass% | mass% | mass% | (piece/number average molecular weight) | Mn | Mw | Mw/Mn |
| P-1 | 52 | 0 | 42 | 3.4 | 6400 | 28800 | 4.5 |
| P-2 | 39 | 0 | 59 | 6.0 | 36000 | 133200 | 3.7 |
| P-3 | 48 | 3 | 46 | 4.7 | 18000 | 113400 | 6.3 |

**[Table 2]**

| | | | Example 1 | Example 2 | Example 3 | Example 4 | Example 5 | Example 6 |
|---|---|---|---|---|---|---|---|---|
| Polymerization liquid | | Parts by mass | 100 | 100 | 100 | 100 | 100 | 100 |
| | Type of copolymer component | | P-1 | P-1 | P-1 | P-1 | P-2 | P-3 |
| | Copolymer component in polymerization liquid | Parts by mass | 18 | 18 | 18 | 18 | 16 | 17 |
| | Vinyl group of divinylbenzene in copolymer | piece/number average molecular weight | 3.4 | 3.4 | 3.4 | 3.4 | 6.0 | 4.7 |
| | Catalyst | Parts by mass | 0.003 | 0.003 | 0.003 | 0.003 | 0.002 | 0.004 |
| | Co-catalyst | Parts by mass | 0.081 | 0.081 | 0.081 | 0.081 | 0.082 | 0.079 |
| Chelating agent 1 (TBC) | | Parts by mass | 0.216 | - | - | - | - | - |
| Chelating agent 2 (Acac) | | Parts by mass | - | 0.432 | 0.216 | 0.108 | 0.192 | 0.204 |
| Chelating agent 3 (AcacOEt) | | Parts by mass | - | - | - | - | - | - |
| Chelating agent 4 (TMEDA) | | Parts by mass | - | - | - | - | - | - |
| Chelating agent 5 (EDTA·4Na) | | Parts by mass | - | - | - | - | - | - |
| Amount of chelating agent added relative to copolymer | | ppm | 12000 | 24000 | 12000 | 6000 | 12000 | 12000 |
| (the number of mol of chelating agent)/(the number of mol of catalyst) | | | 129.41 | 427.05 | 213.53 | 106.76 | 284.70 | 151.25 |
| (the number of mol of chelating agent)/(the number of mol of co-catalyst) | | | 2.552 | 8.423 | 4.211 | 2.106 | 3.698 | 4.078 |
| Gelling upon exposure to the air | | | No | No | No | No | No | No |
| Thickening due to addition of water | | | No | No | No | No | No | No |

**[Table 3]**

| | | | Comparative Example 1 | Comparative Example 2 | Comparative Example 3 | Comparative Example 4 | Comparative Example 5 | Comparative Example 6 | Comparative1 Example 7 | Compa rative 1 Example 8 |
|---|---|---|---|---|---|---|---|---|---|---|
| Polymerization liquid | | Parts by mass | 100 | 100 | 100 | 100 | 100 | 100 | 100 | 100 |
| | Type of copolymer component | | P-1 | P-1 | P-1 | P-1 | P-1 | P-1 | P-2 | P-3 |
| | Copolymer component in polymerization liquid | Parts by mass | 18 | 18 | 18 | 18 | 18 | 18 | 16 | 17 |
| in | Vinyl group of divinylbenzene copolymer | piece/n umber average molecular weight | 3.4 | 3.4 | 3.4 | 3.4 | 3.4 | 3.4 | 60 | 4.7 |
| | Catalyst | Parts by mass | 0.003 | 0.003 | 0.003 | 0.003 | 0.003 | 0003 | 0.002 | 0.004 |
| | Co-catalyst | Parts by mass | 0.081 | 0.081 | 0.081 | 0.081 | 0.081 | 0081 | 0.082 | 0.079 |
| Chelating agent 1 (TBC) | | Parts by mass | - | 0.144 | - | - | - | - | - | - |
| Chelating agent 2 (Acac) | | Parts by mass | - | - | - | - | - | 0054 | - | - |
| Chelating agent 3 (AcacOEt) | | Parts by mass | - | - | 0216 | - | - | - | - | - |
| Chelating agent 4 (TMEDA) | | Parts by mass | - | - | - | 0.216 | | - | - | - |
| Chelating agent 5 (EDTA.4Na) | | Parts by mass | - | - | - | - | 0540 | - | - | - |
| Amount of chelating agent added relative to copolymer | | ppm | - | 8000 | 12000 | 12000 | 12000 | 3000 | - | - |
| (the number of mol of chelating agent)/(the number of mol of catalyst) | | | - | 86.27 | 16427 | 183.91 | 140.58 | 53 38 | - | - |
| (the number of mol of chelating agent)/(the number of mol of co-catalyst) | | | - | 1.702 | 3.240 | 3.627 | 2.773 | 1.053 | - | - |
| Gelling upon exposure to the air | | | Yes | Yes | No | Yes | Yes | Yes | Yes | Yes |
| Thickening due to addition of water | | | Yes | Yes | No | Yes | Yes | Yes | Yes | Yes |

**[Table 4]**

| | | | Example 1 | Example 3 | Example 5 | Example 6 | Comparative Example 1 | Comparative Example 3 | Comparative Example 7 | Comparative Example 8 |
|---|---|---|---|---|---|---|---|---|---|---|
| Copolymer component in LDM polymerization liquid | | Parts by mass | 100 | 100 | 100 | 100 | 100 | 100 | 100 | 100 |
| | Catalyst | Parts by mass | 002 | 0.02 | 0.01 | 0.02 | 002 | 002 | 001 | 002 |
| | Co-catalyst | Parts by mass | 0.45 | 0.45 | 0.455556 | 0.438889 | 0.45 | 0.45 | 0.455556 | 0.438889 |
| Toluene | | Parts by mass | 60 | 60 | 60 | 60 | 60 | 60 | 60 | 60 |
| PERHEXYNE 25B | | Parts by mass | 075 | 0.75 | 0.75 | 075 | 075 | 075 | 075 | 075 |
| Chelating agent 1 (TBC) | | Parts by mass | 1.2 | - | - | - | - | - | - | - |
| Chelating agent 2 (Acac) | | Parts by mass | - | 1.2 | 1.2 | 1.2 | - | - | - | - |
| Chelating agent 3 (AcacOEt) | | Parts by mass | - | - | - | - | - | 1.2 | - | - |
| Chelating agent 4 (TMEDA) | | Parts by mass | - | - | - | - | - | - | - | - |
| Chelating agent 5 (EDTA.4Na) | | Parts by mass | - | - | - | - | - | - | - | - |
| Amount of chelating agent added relative to copolymer | | ppm | 12000 | 12000 | 12000 | 12000 | - | 12000 | - | - |
| Storage elastic modulus at 25°C | | MPa | 3.63 | 5.98 | 3.12 | 4.02 | 2.76 | 3.36 | 2.73 | 2.28 |
| Dielectric constant | | | 2.43 | 2.43 | 2.29 | 2.31 | 2.39 | 2.42 | 2.27 | 2.33 |
| Dielectric tangent | | | 00010 | 0.0010 | 0.0007 | 0.0007 | 0.0010 | 00014 | 0.0007 | 0.0007 |

In order to verify whether or not gelling occurred, LDM polymerization liquid was prepared according to the following procedure. With referring to the manufacturing methods described in Japanese Patent Laid-Open No. H9-40709, International Publication No. WO 00/37517, Japanese Patent Laid-Open No. 2009-161743, and Japanese Patent Laid-Open No. 2010-280771, dimethylmethylenebiscyclopentadienylzirconium dichloride as a catalyst, methylaluminoxane (MMAO-3A toluene solution manufactured by Tosoh Finechem Corporation) as a co-catalyst, cyclohexane as a solvent, and styrene, divinylbenzene (mixture of meta- and para-divinylbenzenes), and ethylene as raw materials, were used, a 10 L autoclave with a stirrer and a heating and cooling jacket was used, and a monomer amount, ratio, polymerization pressure, and polymerization temperature were appropriately changed to obtain respective copolymers with the compositions shown in Table 1. To the obtained polymerization liquid was added 1-Isopropanol to obtain each LDM polymerization liquid. Furthermore, each chelating agent shown in Tables 2 and 3 was introduced to the LDM polymerization liquid, which was then stirred and subjected to evaluation described later.

It is noted that in Tables 2 and 3, the amount of LDM polymerization liquid was taken as 100 parts by mass, and the catalyst, co-catalyst, and chelating agent each in an amount (outer percentage) were shown in the tables. Also, in calculating the number of mol of MMAO in Tables 2 and 3, the molecular weight (58.02)ₘ(100.10)ₙ calculated as m=n=1 to give 158.12, was used in order to take its average.

The chelating agents used are as follows.
Chelating agent 1: TBC (4-tert-butylcatechol, molecular weight: 165.2)
Chelating agent 2: Acac (acetylacetone, molecular weight: 100.12)
Chelating agent 3: AcacOEt (ethyl acetoacetate, molecular weight: 130.14)
Chelating agent 4: TMEDA (tetramethylethylenediamine, molecular weight: 116.24)
Chelating agent 5: EDTA·4Na (tetrasodium ethylenediaminetetraacetate, molecular weight: 380.17)

The obtained polymer (composition) was exposed to the air, and after 5 hours, it was visually confirmed whether or not gelling occurred.

The viscosity of the resin liquid containing the polymer obtained in each Example and Comparative Example was measured as follows. The resin liquid was concentrated using a rotary evaporator, and diluted with toluene to a concentration of 50 mass% to prepare a solution for measurement. A rotational rheometer ("MCR302" manufactured by Anton Paar GmbH) was used to measure the viscosity at 25°C and a shear rate of 1 sec⁻¹. Furthermore, to the polymer was added 5,000 ppm of water relative to the resin, and the viscosity was measured again after 1 hour in the same manner to confirm whether the viscosity had been increased by 50% or more, followed by evaluation thereof as "thickening due to addition of water" in the table.

Furthermore, coordination polymerization was carried out in the same manner as described above, except that for the compositions of some Examples and Comparative Examples, each amount of the components in the LDM polymerization liquid was set to 100 parts by mass according to the formulation shown in Table 4, and a toluene solvent and a curing agent ("PERHEXYNE 25B", 2,5-dimethyl-2,5-bis(tert-butylperoxy)hexyne-3, manufactured by NOF CORPORATION) were further added, then to obtain a polymer. The obtained polymer was evaluated as follows. The results are shown in Table 4.

### <Measurement of storage elastic modulus>

Using a dynamic viscoelasticity measuring apparatus (RSA-G2 manufactured by former Rheometric Scientific (now owned by TA Instruments-Waters LLC)), measurements were performed at a frequency of 1 Hz in a temperature range of -60°C to +300°C. A measurement sample (3 mm × 40 mm) was cut out from a film with a thickness of approximately 0.1 to 0.3 mm and measured to determine a storage elastic modulus in an atmosphere of 25°C. The main measurement parameters in the measurement are as follows.
Measurement frequency: 1 Hz
Rate of temperature rise: 3°C/min
Measurement length of sample: 10 mm
Distortion: 0.1%

### <Measurement of dielectric constant and dielectric loss (dielectric tangent)>

The dielectric properties such as a dielectric constant and dielectric tangent were evaluated in the same manner using a balanced-type circular disk resonator (manufactured by Keysight Technologies, Inc.). In a dielectric property evaluation method in the balanced-type circular disk resonator, two samples (each with 3 cm in diameter and 0.2 to 0.6 mm in thickness) cut out from a sheet were prepared and copper foil was interposed therebetween, and each sample obtained was set in the resonator, and the resonance frequency (f0) and unloaded Q value (Qu) of a peak, which appeared at 27 to 42 GHz, were measured. The dielectric constant was calculated from f0, and the dielectric tangent (tan δc) was calculated from Qu using analysis software (Balanced type circular disk resonator (method) calculator, balanced-type circular disk resonator method analysis software) attached to the resonator. The measurement temperature was 23°C and the humidity was 50% RH.

As shown in Tables 2 and 3, neither Example 1, in which the chelating agent 1 having two oxygen atoms in the molecule was used, nor Examples 2 to 6, in which the chelating agent 2 was used, exhibited gelation or thickening upon addition of water.

On the other hand, Comparative Example 1 and Comparative Examples 7 and 8, in which no chelating agent was added, demonstrated that the gelling occurred and the thickening resulted upon addition of water.

In Comparative Example 2, which used the same chelating agent 1 as in Example 1, the amount thereof was small, as a result of which the gelling occurred and the thickening resulted upon addition of water, which was unsuitable.

In Comparative Example 3, which used the chelating agent 3 that had many oxygen atoms in the molecule and had an ester structure, the dielectric tangent was higher than in Examples, which was unsuitable. Since even a slight difference in a dielectric tangent value (a difference on the order of 0.0001) has a large impact, even the slight decrease in the dielectric tangent can be said to have a significant effect.

In Comparative Example 4, which used the chelating agent 4 that had no oxygen atoms but had a nitrogen atom in the molecule, the gelling occurred and the thickening resulted upon the addition of water, which was unsuitable.

In Comparative Example 5, which used the chelating agent 5 that had many oxygen atoms and also a nitrogen atom in the molecule, the solubility of the chelating agent was poor, as a result of which the gelling occurred and the thickening resulted upon addition of water, which was unsuitable.

In Comparative Example 6, which used the same chelating agent 2 as in Examples 2 to 4, the amount thereof was small, as a result of which the gelling occurred and the thickening resulted upon addition of water, which was unsuitable.

## Claims

1. A composition, comprising:
(A) a curable hydrocarbon-based resin;
(C) a co-catalyst which is a metal compound or a semimetal compound; and
(D) a chelating agent having one or two oxygen atoms in one molecule,
wherein an amount of the component (D) per 1 mol of the component (C) contained in the composition is 2 mol or more.

2. The composition according to claim 1, wherein the component (A) comprises an olefin-aromatic vinyl compound-aromatic polyene copolymer.

3. The composition according to claim 2, wherein the component (A) satisfies the following conditions (1) to (4):
(1) a number average molecular weight of the copolymer is 500 or more and 100,000 or less;
(2) an aromatic vinyl compound monomer unit is an aromatic vinyl compound having 8 or more and 20 or less carbon atoms, and a content of the aromatic vinyl compound monomer unit is 0 mass% or more and 70 mass% or less;
(3) an aromatic polyene monomer unit is one or more selected from polyenes having 5 or more and 20 or less carbon atoms and having a plurality of vinyl groups and/or vinylene groups in the molecule, and a content of the vinyl group and/or vinylene group derived from the aromatic polyene monomer unit is 1.5 pieces or more and less than 20 pieces per number average molecular weight; and
(4) an olefin monomer unit is one or more selected from olefins having 2 or more and 20 or less carbon atoms, and a total of units of the olefin monomer, the aromatic vinyl compound monomer, and the aromatic polyene monomer is 100 mass%.

4. The composition according to any one of claims 1 to 3, further comprising
(B) a resin component comprising one or more selected from the group consisting of a thermoplastic hydrocarbon-based elastomer and a thermoplastic conjugated diene-based polymer.

5. The composition according to any one of claims 1 to 4, wherein an amount of the component (D) is 0.5 parts by mass or more and 10 parts by mass or less per 100 parts by mass of the component (A).

6. The composition according to any one of claims 1 to 5, further comprising
(E) a catalyst which is a metal compound or a semimetal compound.

7. The composition according to claim 6, wherein an amount of the component (D) per 1 mol of the component (E) contained in the composition is 100 mol or more.

8. The composition according to any one of claims 1 to 7, wherein the component (D) is free of a nitrogen atom in its molecule.

9. The composition according to any one of claims 1 to 8, wherein the component (D) comprises one or more selected from the group consisting of 4-tert-butylcatechol and acetylacetone.

10. A cured product of the composition according to any one of claims 1 to 9.

11. A laminate, comprising:
a layer comprising the composition according to any one of claims 1 to 9; and
a metal foil.

12. A single-layer CCL, multilayer CCL, single-layer FCCL, or multilayer FCCL substrate comprising the cured product according to claim 10.

13. A solution, comprising:
the composition according to any one of claims 1 to 9; and
a solvent for dissolving the composition.
